# EUROPÄISCHE PATENTSCHRIFT

(11) **EP 2 122 696 B1**
(45) Veröffentlichungstag und Bekanntmachung des Hinweises auf die Patenterteilung: **23.03.2016**
(21) Anmeldenummer: 08706793.0
(22) Anmeldetag: 23.01.2008
(51) Int. Cl.: H01L 33/48, H01L 33/50

(54) **ANORDNUNG ZUR ERZEUGUNG VON MISCHLICHT UND VERFAHREN ZUR HERSTELLUNG EINER SOLCHEN ANORDNUNG**
ARRANGEMENT FOR GENERATING MIXED LIGHT, AND METHOD FOR THE PRODUCTION OF SUCH AN ARRANGEMENT
DISPOSITIF DE PRODUCTION DE LUMIÈRE MIXTE, ET PROCÉDÉ DE FABRICATION D'UN TEL DISPOSITIF

(30) Priorität: 25.01.2007 DE 102007003808; 08.02.2007 DE 102007006349
(43) Veröffentlichungstag der Anmeldung: 25.11.2009
(73) Patentinhaber: OSRAM Opto Semiconductors GmbH, 93055 Regensburg (DE)
(72) Erfinder: BRAUNE, Bert, 93173 Wenzenbach (DE); KRÄUTER, Gertrud, 93051 Regensburg (DE)
(74) Vertreter: Epping - Hermann - Fischer
(86) Internationale Anmeldenummer: PCT/DE2008/000125
(87) Internationale Veröffentlichungsnummer: WO 2008/089740

(56) Entgegenhaltungen:
- DE-A1- 19 918 370
- JP-A- 2004 349 646
- JP-A- 2004 349 647
- US-A1- 2004 041 222
- US-A1- 2004 183 081
- US-A1- 2005 093 430
- US-A1- 2006 267 041
- US-A1- 2007 012 940

## Beschreibung

Die Erfindung bezieht sich auf eine Anordnung beziehungsweise ein Verfahren zur Herstellung der Anordnung, das zur Erzeugung eines Mischlichtes mit mindestens einem Halbleiterbauelement dient.

Heutzutage werden in vielen Bereichen Mischlichtquellen verwendet. So sind zum Beispiel in Bereichen der Bildwiedergabebeziehungsweise Projektionstechnik aber auch in einfachen Anwendungen wie Taschenlampen, Mischlichtquellen zu finden. Abhängig von ihrer Verwendung werden dabei Mischlichtquellen verschiedener Farben erzeugt.

Zur Verwendung in Taschenlampen wird eine Mischlichtquelle vorzugsweise als Weißlichtquelle ausgeführt. Hierbei ist es Ziel, möglichst viele Wellenlängen des sichtbaren Wellenlängenbereiches, also Wellenlängen von 380nm bis 780nm, gleichzeitig zu erzeugen und auszusenden. Für den Betrieb einer Mischlichtquelle mittels Energiespeicher ist neben einer hohen Farbtreue auch eine sehr gute Energiebilanz vorteilhaft. Dadurch ist es einerseits gewährleistet, angestrahlte Objekte möglichst authentisch zu reflektieren und somit eine gewohnte subjektive Wahrnehmung der Objekte zu erhalten. Andererseits ist eine hohe Energieeffizienz vorteilhaft, um einen zeitlich langen Betrieb einer Mischlichtquelle aufrecht zu erhalten.

Mischlichtquellen werden heutzutage häufig mittels Halbleiter generiert und durch gleichzeitige additive Überlagerung so genannter Primärfarben erzeugt. Diese Primärfarben sind durch einen emittierenden Halbleiterchip, zum Beispiel LED, erzeugte elektromagnetische Strahlungen eines, relativ zum sichtbaren Wellenlängenbereich, schmalen Wellenlängenbereiches. Beispielsweise stellt eine Erzeugung von Wellenlängen im Bereich von 625nm - 740 nm die Farbe Rot, von 520nm - 565nm die Farbe Grün oder 450nm - 500nm die Farbe Blau dar. Andere Wellenlängenbereiche sind ebenfalls denkbar. Durch eine gleichzeitige Überlagerung dieser Farben in den unterschiedlichsten Kombinationen werden verschiedenfarbige Mischlichter erzeugt.

Diese Überlagerung der Primärfarben wurde bisher mittels einer additiven Mischung durchgeführt. Beispielsweise in der Bildwiedergabe beziehungsweise Projektionstechnik werden Subpixel, also Bildpunktunterelemente, der Farben Rot, Grün und Blau unterschiedlich angesteuert. Durch die Ansteuerung werden die Farben unterschiedlich überlagert. Bei hinreichender Entfernung des Betrachters vom Bildwiedergabegerät bzw. der Projektionsfläche und durch eine hohe Anzahl solcher Bildpunkte entsteht der Eindruck eines vielfarbigen Bildes durch additive Farbmischung.

Es wird darüber hinaus noch eine andere Möglichkeit zur Erzeugung von Mischlichtquellen angewandt. Hierbei werden zumeist Halbleiterbauelemente verwendet, die elektromagnetische Strahlung eines bestimmten schmalen Wellenlängenbereiches aussenden. Diese Strahlung wird fortlaufend als Primärstrahlung bezeichnet. Dabei muss sich diese elektromagnetische Strahlung nicht zwingend komplett oder teilweise im sichtbaren Wellenlängenbereich befinden. Diese Strahlung wird mittels eines Lumineszenzkonversionselementes zumindest teilweise in eine Sekundärwellenlänge umgesetzt.

Zur Generierung dieser Primärstrahlung werden aktive Schichten eines pn-Überganges eines im Halbleiterbaulement befindlichen Halbleiterchips beispielsweise unterschiedlich dotiert. Die dadurch entstehenden unterschiedlichen Energieniveaudifferenzen der Energieniveauschemata, auch als Bandlücken bezeichnet, führen zu einer Emission von Licht unterschiedlicher Wellenlänge. Die Wellenlänge dieses ausgesendeten Lichtes ist dabei direkt abhängig vom Energieniveauunterschied und mittels der Dotierung bedingt einstellbar.

Die ausgesendete Primärwellenlänge des Halbleiterchips wird mittels eines Lumineszenzkonversionselementes zumindest teilweise in eine Sekundärwellenlänge umgewandelt. Hierzu ist es wichig, dass das Lumineszenkonversionselement derart in den Strahlengang der Primärstrahlung des Halbleiterchips eingebracht wird, dass die Gesamtheit der ausgesendeten Photonen der Primärstrahlung einen optisch gleichlangen Weg im Lumineszenzkonversionselement zurücklegen müssen, damit alle zu konvertierenden Photonen gleichartig zur neuen Sekundärwellenlänge konvertieren.

Halbleiterbauelemente, die mittels eines Lumineszenzkonversionselementes diese Primärwellenlänge in einer Sekundärwellenlänge umsetzen, werden über sehr kostenintensive und aufwändige Prozesse hergestellt. Ziel bei der Herstellung ist es vor allem, das Lumineszenzkonversionselement möglichst derart in den Strahlengang des emitierenden Halbleiterchips einzubringen, dass das erzeugte Mischlicht ein, über dem gesamten Ausstrahlungsbereich des Halbleiterbauelementes konstantes Wellenlängenspektrum aufweist. Um diese Konstanz zu realisieren, sind derzeit Siebdruck- und Sedimentationsprozesse üblich. Eine andere Art ist die räumliche Trennung des Lumineszenzkonversionselementes vom emitierenden Halbleiterchip.

Bei der Herstellung in einem Siebdruckprozess muss beispielsweise gewährleistet sein, dass die Kontaktflächen des Halbleiterchips freigehalten werden. Dazu ist es nötig, die Bondstellen zu dekontaminieren. Ein weiteres Problem ist die geringe Kantenlänge der emittierenden Halbleiterchips. Weiterhin ist es mit einigen Mikrometern heutzutage schwierig, einen Leuchtstoff direkt auf den Halbleiterchip zu platzieren. Diese Fertigungsvariante und die dazugehörige nötige Reiningung der Fertigungsgerätschaften sind aufgrund der Aufwendigkeit sehr kostenintensiv.

Für die Herstellung einer Mischlichtquelle mittels eines Sedimentationsprozesses wird der Leuchtstoff mit einem Harz vermischt und auf den Chip platziert. Die unterschiedliche Viskosität beider Stoffe macht man sich nun zu Nutzen. Einerseits werden beide Stoffe in Folge der andauernden Zeit voneinander getrennt, in dem sich das Leuchtstoffmaterial von dem dünnflüssigem Harz absetzt dadurch eine Trennung beider Stoffe vollzogen wird. Andererseits ist die Viskosität ebenfalls über einen Temperaturprozess kontrollierbar, bei der sich der Leuchtstoff ab einer bestimmten Schwelltemperatur absetzt.

Durch beide Verfahren ist es möglich, einen Leuchtstoff derart zu platzieren, dass eine Schwankung des Wellenlängenspektrums der emitierten Mischlichtwellenlänge in Bezug auf die Abstrahlcharakteristik des gesamten Halbleiterbauelemenmöglichst gering gehalten wird. Nachteilig bei diesen Prozessen ist allerdings der große Aufwand, um diese Konstanz zu erzielen.

Die Druckschrift US 2004/0183081 A1 beschreibt eine LED mit einem an der Oberseite als Linse ausgeformten Deckelement, das über einem Grundelement mit einem LED-Chip angeordnet ist. An der Unterseite des Deckelements ist über dem LED-Chip eine Kavität ausgeformt, mittels derer ein Wellenlängenkonversionsmedium über dem LED-Chip ausgeformt ist. Weiterhin wird ein Deckelement mit Plastikstiften beschrieben, die in Löcher des Grundelements eingreifen.

Die Druckschrift US 2006/0267041 A1 beschreibt eine LED mit einem Grundkörper mit einer Vertiefung, in der ein Chip angeordnet ist. Darüber ist eine als Linse ausgeformte transparente Schicht mit einer über eine Öffnung befüllbaren Rinne angeordnet, die sich oberhalb des Chips erstreckt und in die ein Fluoreszenzpulver-gefüllter Klebstoff eingebracht ist.

Die Druckschrift US 2004/0041222 A1 beschreibt ein LED-Chip-Package mit einer unteren Wärmesenke und darauf einer oberen Wärmesenke mit einer Öffnung, in der eine LED-Anordnung aufgebracht ist und die mit einem Verkapselungsmaterial gefüllt ist. Auf dem Verkapselungsmaterial und mittels dessen befestigt ist eine Linse angeordnet, die der LED-Anordnung zugewandt eine Öffnung aufweist, die mit einem Wellenlängenkonversionsstoff gefüllt werden kann.

Die Druckschrift US 2005/0093430 A1 beschreibt Lichtquellen, die jeweils eine LED auf einem Träger aufweisen. Beispielsweise ist über der LED eine Linse angeordnet, die einen inneren Schichtbereich mit einem mit Farbstoff gemischten klaren Material und einen äußeren Schichtbereich nur mit einem klaren Material aufweist.

Aufgabe der hier vorliegenden Erfindung ist die Erzeugung eines Mischlichtes, welches auch unter einfachen Prozessbedingungen hergestellt werden kann und ein stabiles Wellenlängenspektrum besitzt. Darüber hinaus soll eine möglichst geringe Schwankung des Wellenlängenspektrums des ausgesendeten Mischlichtes über den Abstrahlort und eine hohe Energieeffizienz erzielt werden. Diese Aufgabe wird mit den in den nebengeordneten Patentansprüchen angegebenen Maßnahmen gelöst.

Zur Erzeugung eines Mischlichtes ist erfindungsgemäß eine Anordnung mit mindestens einem Halbleiterchip gemäß Anspruch 1 angegeben, welches eine elektromagnetische Primärstrahlung aussendet. Dieser Halbleiterchip weist in seinem Strahlengang ein Lumineszenzkonversionselement, ein Verbindeelement und ein Trägerelement auf. Hierbei ist das Trägerelement ein, das Lumineszenzkonversionselement formendes Element, wobei das Lumineszenzkonversionselement mittels des Trägerelementes in den Strahlengang eingebracht wird. Vorteilhaft ist hierbei das Trägerelement, das durch seine Formgebung das Lumineszenzkonversionselement in den Strahlengang einbringt.

Weiterhin ist ein Verfahren zur Herstellung einer Anordung gemäß Anspruch 6 angegeben, welches ein Mischlicht erzeugt. Hierbei wird eine, durch einen Halbleiterchip erzeugte elektromagnetische Primärstrahlung mittels eines Lumineszenzkonversionselementes zumindest teilweise in eine elektromagnetische Sekundärstrahlung konvertiert. Das Lumineszenzkonversionselement wird dabei derart mittels des Trägerelementes in den Strahlengang der Primärstrahlung des Halbleiterchips positioniert und mit diesem verbunden, dass eine homogene Verteilung des Lumineszenzkonversionselementes auf dem Trägerelement erreicht wird. Eine maximale Transmission des Mischlichtes wird durch vorteilhafte Ausbildung der Verbindeelemente und der Trägerelemente in der Form erreicht, dass diese beiden Elemente für das auszusendende Mischlichtwellenlänge transparent sind. Durch die Herstellung einer Anordnung auf diese Weise ist der Herstellungsprozess für eine solche Anordnung wesentlich einfacher.

Weitere vorteilhafte Ausgestaltungen der Erfindung sind in den untergeordneten Ansprüchen angegeben.

Zur Erzeugung eines Mischlichtes bestimmter Wellenlängen wird eine Anordnung beschrieben, welche mit Hilfe von Halbleiterchips realisiert werden. Wobei mindestens ein Halbleiterchip ein Lumineszenzkonversionselement im Strahlengang aufweist und dieses Halbleiterbauelement eine Primärwellenlänge aussendet. Diese elektromagnetische Primärstrahlung wird zumindest teilweise in eine elektromagnetische Sekundärstrahlung konvertiert. Der Vorteil dieser Anordnung ist eine Erzeugung eines Mischlichtes mit Hilfe von einem Halbleiterbauelement anstelle von mehreren Halbleiterbauelementen. Dadurch, dass das formende Trägerelement das Lumineszenzkonversionselement in den Strahlengang einbringt, wird eine Konstanz des Wellenlängenbereiches des ausgesendeten Mischlichtes über dem Abstrahlort erreicht.

Durch Positionierung des Lumineszenzkonversionselementes in dem Trägerelement erreicht man eine gezielte Positionierung und ermöglicht eine maximale Konversion der Primärstrahlung. Vorteilhafterweise wird das Trägerelement derart geformt, dass das Lumineszenzkonversionselement homogen verteilt ist. Dadurch wird eine homogene Lumineszenzkonversionsschicht erzeugt und ein konstanter optischer Weg für die Gesamtheit der zu konvertierenden Photonen durch das Konversionselement erreicht.

Durch Positionierung des Lumineszenzkonversionselementes in einer geformten Kavität im Trägerelement ist eine exakte Positionierung möglich. Der Vorteil hierbei ist die einfache prozesstechnische Realisierung dieser Anordnung. Ebenfalls kann in diese Kavität ein Verbindeelement eingebracht. Durch die Form der Kavität des Trägerelementes wird dieses Verbindeelement ebenfalls homogen platziert sowie verteilt und somit ein konstanter optischer Laufweg der Photonen der elektromagnetischen Primärstrahlung durch das Verbindemittel erreicht. Hiernach werden die Photonen Licht einer elektromagnetischen Sekundärstrahlung aussenden.

Durch Ausbildung des Lumineszenzkonversionselementes in Form eines Leuchtstoffes ist es möglich, das Lumineszenzkonversionselement in Verbindung mit der Harzmischung in den Strahlengang des Halbleiterchips einzusetzen.

Durch Ausbildung des Trägerelementes als optisches Element ist es möglich, die ausgestrahlten Mischlichtwellenlängen optisch abzulenken, um beispielsweise einen Linseneffekt zu erzeugen. Eine Schwankung des Wellenlängenbereiches des auszusendenen Mischlichtes über den Abstrahlort wird hierdurch kompensiert und darüber hinaus eine höhere Energieeffizienz des Halbleiterbauelementes erreicht.

In vorteilhafter Weise wird die Oberfläche des Halbleiterchips sowie die Oberfläche des Verbindeelementes planar ausgestattet. Dadurch wird eine Aussendung des Lichtes parallel zur Normalen der Oberfläche erzielt und ein elektromagnetisches Primärstrahlungsstreulicht verhindert. Das Verbindeelement ist in einer weiteren vorteilhaften Weise transparent für das abzustrahlende Mischlicht gestaltet. Dadurch werden Energieeffizienzen vergrößert, da nun das Verbindeelement keine Energie absorbiert. Die nötige Haltekraft des Verbindeelementes zwischen Trägerelement und Halbleiterchip wird beispielsweise durch Adhäsion oder Druck- und Zugkräfte erzeugt.

Nachfolgend wird die Erfindung anhand von Ausführungsbeispielen mit Bezugnahme auf die Zeichnungen erläutert, wobei die Figuren gleicher oder gleich wirkender Bestandteile jeweils mit den gleichen Bezugszeichen gezeichnet sind. Die dargestellten Elemente sind nicht als maßstabsgerecht anzusehen, vielmehr können einzelne Elemente zum besseren Verständnis übertrieben groß beziehungsweise übertrieben vereinfacht dargestellt sein. Es zeigen:
- Figur 1: schematische Darstellung eines Trägerelementes mit einer Kavität für ein Lumineszenzkonversionselement und ein Verbindeelement,
- Figur 2: schematische Darstellung eines ersten Ausführungsbeispiels einer Anordnung zur Erzeugung von Mischlicht,
- Figur 3: schematische Darstellung eines zweiten Ausführungsbeispiels einer Anordnung zur Erzeugung von Mischlicht.

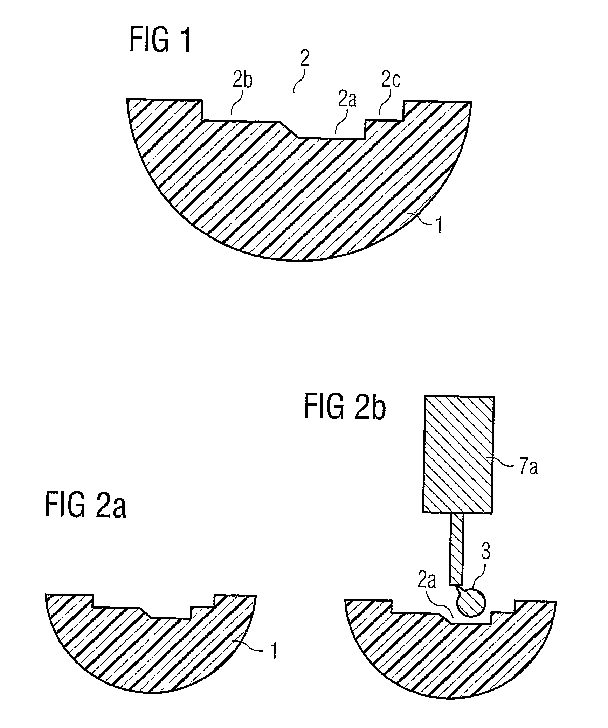

In Figur 1 ist eine schematische Darstellung eines Trägerelementes 1 mit einer Kavität 2 für ein Lumineszenzkonversionselement 3 und ein Verbindeelement 4 dargestellt.

Das Trägerelement 1 ist hier in Form einer Halbkugel ausgeführt. In dieser Darstellung wird ein zweidimensionaler Schnitt durch den Mittelpunkt der Halbkugel gezeigt. An der Grundfläche der Halbkugel, die gleichzeitig auch Kontaktfläche zum LED-Träger 5 ist, ist die Oberfläche nicht planar ausgebildet, sondern durch eine offene Kavität 2 charakterisiert. Diese Kavität ist in drei Teilräume 2a, 2b und 2c unterteilt, die sich auf unterschiedlichen, zur Grundfläche parallelen, Ebenen befinden. Die Teilräume 2b und 2c befinden sich dabei auf gleicher Ebene. Die vom Mittelpunkt der Halbkugel weiter entfernte Ebene der Kavität 2a dient zur Platzierung und Positionierung eines Lumineszenzkonversionselementes 3. Die Kavität 2b dient zur Positionierung und Platzierung eines Verbindeelementes 4, die Kavität 2c stellt einen Platzhalter für die Bondverdrahtung 5b dar.

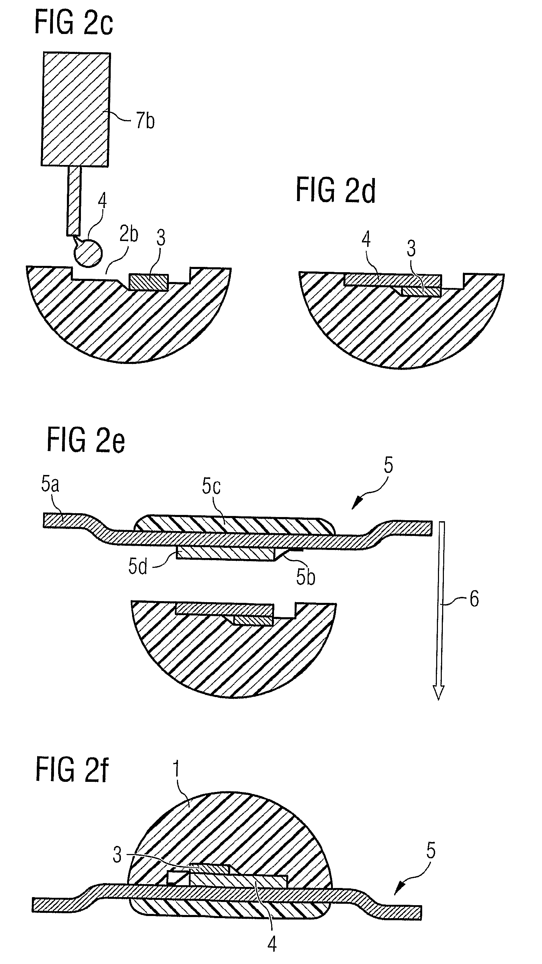

Figur 2 zeigt eine schematische Darstellung eines ersten Ausführungsbeispiels einer Anordnung zur Erzeugung eines Mischlicht. In Figur 2a ist die in Figur 1 vorgestellte Form des Trägerelements 1 erneut aufgeführt. Mittels einer Dosiereinheit 7a wird ein Lumineszenzkonversionselement 3 in Figur 2b in die dafür vorgesehene Kavität für das Lumineszenzkonversionselement 2a platziert.

In Figur 2c wird zusätzlich ein Verbindeelement 4 mittels einer weiteren Dosiereinheit 7b der Anordnung zugefügt, wobei das Verbindelement 4 in die dafür vorgesehene Kavität 2b eingebracht wird. In diesem Ausführungsbeispiel wird ein Verbindelement in Form eines Klebemittels verwendet. Das Lumineszenzkonversionselement 3 ist hier bereits in der Kavität 2a positioniert. In Figur 2d ist nun das Trägerelement 1 mit platzierten und homogen angeordneten Lumineszenzkonversionselement 3 und Verbindeelement 4 dargestellt. In Figur 2e wird nun ein LED Träger 5 bestehend aus Kontaktanschlüssen 5a, Bondverdrahtung 5b, Gehäuse 5c sowie einem Halbleiterchip 5d mit dem Aufbau aus Figur 2d in einem Zusammenführungsschritt 6 kombiniert. Die Figur 2f zeigt die komplette Anordnung bestehend aus Trägerelement 1, Leuchtstoff 3, Verbindeelement 4 sowie LED Träger 5.

Es ist anzumerken, das ein Verbindeelement dazu dient, eine Haltekraft aufzubringen. In der Ausführung der Figur 2 ist das Verbindemittel als ein Adhäsion gebendes Element, wie zum Beispiel ein Klebemittel, vergesehen, mit welchem die Haltekraft zwischen LED Träger 5 und Trägerelement 1 idealerweise auf atomarer Ebene erreicht wird.

Bei dem in Figur 2 dargestellten Ausführungsbeispiel dient die Kavität zur Platzierung des Lumineszenzkonversionselement 3, des Verbindeelement 4 und auch zur homogenen Anordnung beider Elemente. Gemäß Figur 2 sind die planar eingebrachten Elemente erkennbar. Idealerweise ist die Oberfläche des Halbleiterchips 5e ebenfalls planar. Mit dieser Maßnahme erfolgt bevorzugt ein Aussenden der Primärstrahlung parallel zur Normalen der Oberfläche.

Durch eine exakte Form der Kavität ist es nunmehr möglich, eine Platzierung, Positionierung und homogene Anordnung dieser Elemente 3 und 4 vorzunehmen, ohne aufwendige Prozesse, wie Siebdruck oder Sedimentation zu benötigen. Durch die homogene Anordnung beider Stoffe wird die ausgesendete Primärwellenlänge auf jeder Strecke des Strahlenganges den gleichen optischen Weg durch beide Elemente 3 und 4 zurücklegen und somit zumindest teilweise die in der Primärstrahlung vorrangig befindliche Primärwellenlänge in eine in der konvertierten Sekundärstrahlung befindliche Sekundärwellenlänge umwandeln.

Ist das Trägerelement zusätzlich als optisches Element ausgeführt, wie zum Beispiel als Streu oder Sammelinse, wird zum einen eine optische Ablenkung des Mischlichtes erzeugt, zum anderen eine Bündelung und damit eine Intensitätssteigerung der Lichtstärke erzielt. Durch die gegebene Geometrie sind Schwankungen des Wellenlängenbereiches des erzeugten Mischlichtes minimal.

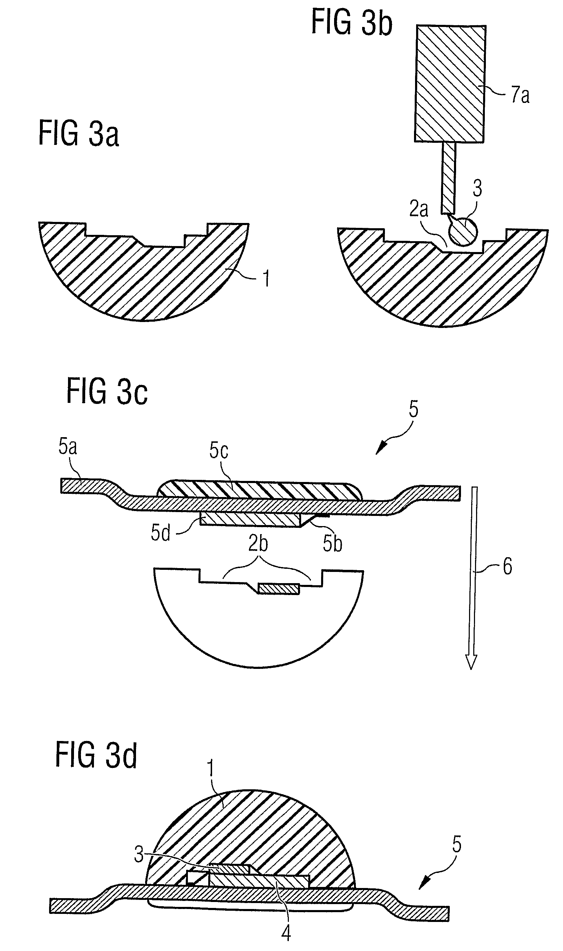

Figur 3 zeigt eine schematische Darstellung einer alternativen Anordnung zur Erzeugung von Mischlicht. Wesentlicher Unterschied zu den vorangegangenen Figuren ist die Form des Trägerelementes 1. Hierbei ist die Kavität 2 lediglich für das Lumineszenzkonversionselement 3 und die Bondverdrahtung 5b vorgesehen. Die Figur 3b ist equivalent zur der Figur 2c. In Figur 3c wird das mit Lumineszenzkonversionselement 3 ausgestattete Trägerelement 1 mit dem LED Träger 5 zusammengeführt 6. In Figur 3d wird die komplette Anordnung mit Trägerelement 1, LED Träger 5, Lumineszenzkonversionselement 3 sowie eines Verbindeelementes 4 dargestellt.

In dieser alternativen Anordnung sind die Geometrien von Halbleiterchip 5d und Trägerelement 1 so gewählt, dass eine Presspassung beim Zusammenführen 6 entsteht. Diese Zusammenführung erzeugt eine Haltekraft, die allein durch Reibung zwischen den Berührungsflächen von Halbleiterchip 5d und Trägerelement 1 entsteht. Die mechanische Haltekraft kann zudem durch das Vorsehen von Hinterschneidungen, speziellen geometrischen Ausformungen, Rastungen, zusätzliche mechanische Halteelemente etc., was nicht näher dargestellt ist, aufgebracht oder erhöht werden.

Die beschriebene Erfindung betrifft eine Anordnung sowie ein Verfahren zur Herstellung einer solchen Anordnung, die zur Erzeugung von Mischlicht dient. Hierbei weist ein eine elektromagnetische Primärstrahlung aussendendes Halbleiterchip ein Lumineszenzkonversionselement im Strahlengang der Primärstrahlung auf. Weiterhin beinhalet die Anordnung ein Verbindeelement und ein Trägerelement, wobei das Trägerelement das Lumineszenzkonversionselement und das Verbindeelement trägt und formt.

## Patentansprüche

1. Anordnung zur Erzeugung von Mischlicht, mit mindestens einem, eine elektromagnetische Primärstrahlung aussendenden Halbleiterchip (5d), einem Lumineszenzkonversionselement (3) im Strahlengang der Primärstrahlung des Halbleiterchips (5d), einem Verbindeelement (4) und einem, das Lumineszenzkonversionselement (3) formenden Trägerelement (1),
wobei das Lumineszenzkonversionselement (3) die Primärstrahlung zumindest teilweise in eine elektromagnetische Sekundärstrahlung konvertiert,
wobei das Lumineszenzkonversionselement (3) mittels des Trägerelementes (1) in den Strahlengang eingebracht ist,
wobei zur Positionierung des Lumineszenzkonversionselementes (3) eine Kavität (2) im Trägerelement (1) vorgesehen ist, in der das Lumineszenzkonversionselement und zusätzlich das Verbindeelement angeordnet sind,
wobei die Kavität (2) in drei Teilräume (2a, 2b, 2c) unterteilt ist, die von unterschiedlichen, zu einer Grundfläche parallelen Ebenen begrenzt werden,
wobei einer der drei Teilräume (2a, 2b, 2c) der Kavität (2) im Trägerelement (1) zur Positionierung des Verbindeelements (4) dient und ein weiterer der drei Teilräume (2a, 2b, 2c) zur Positionierung des Lumineszenzkonversionselementes (3) dient,
wobei der Halbleiterchip (5d) mit einem LED-Träger (5) verbunden ist und die Grundfläche eine Kontaktfläche zum LED-Träger ist und das Lumineszenzkonversionselement (3) mittels des Trägerelementes (1) gegenüber dem Halbleiterchip (5d) positioniert ist und
wobei das Verbindeelement (4) eine Haltekraft zwischen Trägerelement (1) und LED-Träger (5) durch Adhäsion erzeugt.

2. Anordnung nach einem der vorherigen Ansprüche, wobei das Lumineszenzkonversionselement (3) durch das Trägerelement (1) derart geformt ist, dass das Lumineszenzkonversionselement (3) homogen angeordnet ist.

3. Anordnung nach einem der vorherigen Ansprüche, wobei das Trägerelement (1) ein optisches Element ist.

4. Anordnung nach einem der vorherigen Ansprüche, wobei die Oberfläche des Halbleiterchips (5e) und/oder die Oberfläche des Verbindeelements (4) planar ist.

5. Anordnung nach einem der vorherigen Ansprüche, wobei das Verbindeelement (4) transparent für das auszustrahlende Mischlicht ist.

6. Verfahren zur Herstellung einer Anordnung zur Erzeugung von Mischlicht, bei der zumindest ein eine elektromagnetische Primärstrahlung aussendender Halbleiterchip (5d) vorgesehen ist und dabei ein Lumineszenzkonversionselement (3) mittels eines Trägerelementes (1) im Strahlengang der Primärstrahlung positioniert und mittels eines Verbindeelementes (4) mit dem Halbleiterchip (5d) verbunden ist,
wobei die Positionierung durch eine Kavität (2) im Trägerelement (1) erfolgt, in der das Lumineszenzkonversionselement und zusätzlich das Verbindeelement angeordnet werden, wobei das Lumineszenzkonversionselement (3) die Primärstrahlung zumindest teilweise in eine elektromagnetische Sekundärstrahlung konvertiert,
wobei die Kavität (2) in drei Teilräume (2a, 2b, 2c) unterteilt ist, die von unterschiedlichen, zu einer Grundfläche parallelen Ebenen begrenzt werden,
wobei einer der drei Teilräume (2a, 2b, 2c) der Kavität (2) im Trägerelement (1) zur Positionierung des Verbindeelementes (4) dient und ein weiterer der drei Teilräume (2a, 2b, 2c) zur Positionierung des Lumineszenzkonversionselementes (3) dient und
wobei durch das Verbindeelement (4) eine Haltekraft zwischen dem Trägerelement (1) und einem mit dem Halbleiterchip (5d) verbundenen LED-Träger (5) mittels Adhäsion erzeugt wird und die Grundfläche eine Kontaktfläche zum LED-Träger ist.

7. Verfahren nach Anspruch 6, wobei das Lumineszenzkonversionselement (3) durch die Kavität homogen angeordnet wird.

## Claims

1. Arrangement for generating mixed light, comprising at least one semiconductor chip (5d) that emits an electromagnetic primary radiation, a luminescence conversion element (3) in the beam path of the primary radiation of the semiconductor chip (5d), a connecting element (4) and a carrier element (1) that shapes the luminescence conversion element (3),
wherein the luminescence conversion element (3) converts the primary radiation at least partly into an electromagnetic secondary radiation,
wherein the luminescence conversion element (3) is introduced into the beam path by means of the carrier element (1),
wherein, for the positioning of the luminescence conversion element (3), a cavity (2) is provided in the carrier element (1), in which cavity the luminescence conversion element and additionally the connecting element are arranged,
wherein the cavity (2) is subdivided into three subareas (2a, 2b, 2c) which are bounded by different planes parallel to a base area,
wherein one of the three subareas (2a, 2b, 2c) of the cavity (2) in the carrier element (1) is used to position the connecting element (4) and a further one of the three subareas (2a, 2b, 2c) is used to position the luminescence conversion element (3),
wherein the semiconductor chip (5d) is connected to an LED carrier (5) and the base area is a contact area for the LED carrier, and the luminescence conversion element (3) is positioned opposite the semiconductor chip (5d) by means of the carrier element (1) and
wherein the connecting element (4) generates a holding force between the carrier element (1) and the LED carrier (5) by adhesion.

2. Arrangement according to one of the preceding claims,
wherein the luminescence conversion element (3) is shaped by the carrier element (1) in such a way that the luminescence conversion element (3) is arranged homogeneously.

3. Arrangement according to one of the preceding claims,
wherein the carrier element (1) is an optical element.

4. Arrangement according to one of the preceding claims,
wherein the surface of the semiconductor chip (5e) and/or the surface of the connecting element (4) is planar.

5. Arrangement according to one of the preceding claims,
wherein the connecting element (4) is transparent to the mixed light to be emitted.

6. Method for producing an arrangement for generating mixed light, wherein at least one semiconductor chip (5d) that emits an electromagnetic primary radiation is provided and thereby a luminescence conversion element (3) is positioned in the beam path of the primary radiation by means of a carrier element (1) and is connected to the semiconductor chip (5d) by means of a connecting element (4),
wherein the positioning is effected by means of a cavity (2) in the carrier element (1), in which cavity the luminescence conversion element and additionally the connecting element are arranged,
wherein the luminescence conversion element (3) converts the primary radiation at least partly into an electromagnetic secondary radiation,
wherein the cavity (2) is subdivided into three subareas (2a, 2b, 2c) which are bounded by different planes parallel to a base area, wherein one of the three subareas (2a, 2b, 2c) of the cavity (2) in the carrier element (1) is used to position the connecting element (4) and a further one of the three subareas (2a, 2b, 2c) is used to position the luminescence conversion element (3), and
wherein the connecting element (4) generates a holding force between the carrier element (1) and an LED carrier (5) connected to the semiconductor chip (5d) by adhesion, and the base area is a contact area for the LED carrier.

7. Method according to Claim 6, wherein the luminescence conversion element (3) is arranged homogeneously by means of the cavity.

## Revendications

1. Arrangement pour générer de la lumière combinée, comprenant au moins une puce en semiconducteur (5d) émettant un rayonnement primaire électromagnétique, un élément de conversion de luminescence (3) dans le trajet de rayon du rayonnement primaire de la puce en semiconducteur (5d), un élément de liaison (4) et un élément porteur (1) modelant l'élément de conversion de luminescence (3),
l'élément de conversion de luminescence (3) convertissant le rayonnement primaire au moins partiellement en un rayonnement secondaire électromagnétique,
l'élément de conversion de luminescence (3) étant introduit dans le trajet de rayon au moyen de l'élément porteur (1),
une cavité (2) étant prévues dans l'élément porteur (1) pour le positionnement de l'élément de conversion de luminescence (3), dans laquelle sont disposés l'élément de conversion de luminescence et en plus l'élément de liaison,
la cavité (2) étant divisée en trois espaces partiels (2a, 2b, 2c) qui sont délimités par des plans différents parallèles à une surface de base,
l'un des trois espaces partiels (2a, 2b, 2c) de la cavité (2) dans l'élément porteur (1) servant au positionnement de l'élément de liaison (4) et un autre des trois espaces partiels (2a, 2b, 2c) servant au positionnement de l'élément de conversion de luminescence (3),
la puce en semiconducteur (5d) étant reliée à un support de LED (5) et la surface de base étant une surface de contact avec le support de LED et l'élément de conversion de luminescence (3) étant positionné par rapport à la puce en semiconducteur (5d) au moyen de l'élément porteur (1) et
l'élément de liaison (4) produisant par adhérence une force de maintien entre l'élément porteur (1) et le support de LED (5).

2. Arrangement selon l'une des revendications précédentes, avec lequel l'élément de conversion de luminescence (3) est modelé par l'élément porteur (1) de telle sorte que l'élément de conversion de luminescence (3) est disposé de manière homogène.

3. Arrangement selon l'une des revendications précédentes, avec lequel l'élément porteur (1) est un élément optique.

4. Arrangement selon l'une des revendications précédentes, avec lequel la surface de la puce en semiconducteur (5e) et/ou la surface de l'élément de liaison (4) sont planes.

5. Arrangement selon l'une des revendications précédentes, avec lequel l'élément de liaison (4) est transparent pour la lumière combinée à émettre.

6. Procédé de fabrication d'un arrangement pour générer de la lumière combinée, avec lequel il existe au moins une puce en semiconducteur (5d) émettant un rayonnement primaire électromagnétique et un élément de conversion de luminescence (3) est ici positionné dans le trajet de rayon du rayonnement primaire au moyen d'un élément porteur (1) et relié à la puce en semiconducteur (5d) au moyen d'un élément de liaison (4)
le positionnement étant réalisé par une cavité (2) dans l'élément porteur (1), dans laquelle sont disposés l'élément de conversion de luminescence et en plus l'élément de liaison, l'élément de conversion de luminescence (3) convertissant le rayonnement primaire au moins partiellement en un rayonnement secondaire électromagnétique,
la cavité (2) étant divisée en trois espaces partiels (2a, 2b, 2c) qui sont délimités par des plans différents parallèles à une surface de base,
l'un des trois espaces partiels (2a, 2b, 2c) de la cavité (2) dans l'élément porteur (1) servant au positionnement de l'élément de liaison (4) et un autre des trois espaces partiels (2a, 2b, 2c) servant au positionnement de l'élément de conversion de luminescence (3), et
une force de maintien entre l'élément porteur (1) et un support de LED (5) relié à la puce en semiconducteur (5d) étant produite par adhérence par l'élément de liason (4) et la surface de base étant une surface de contact avec le support de LED.

7. Procédé selon la revendication 6, selon lequel l'élément de conversion de luminescence (3) est disposé de manière homogène par la cavité.
